# FASCICULE DE BREVET EUROPEEN

(11) **EP 3 158 103 B1**
(45) Date de publication et mention de la délivrance du brevet: **15.01.2020**
(21) Numéro de dépôt: 15726052.2
(22) Date de dépôt: 20.05.2015
(51) Int. Cl.: C23C 8/08, D02G 3/48, D07B 1/06

(54) **RENFORT, METALLIQUE OU METALLISE, GRAPHENISE**
METALLISCHE ODER METALLISIERTE, GRAPHENISIERTE VERSTÄRKUNG
METALLIC OR METALLISED, GRAPHENISED REINFORCEMENT

(30) Priorité: 18.06.2014 FR 1455569
(43) Date de publication de la demande: 26.04.2017
(73) Titulaire: Compagnie Générale des Etablissements Michelin, 63000 Clermont-Ferrand (FR)
(72) Inventeur: GRASS, Robert, Nikolaus, CH-8057 Zurich (CH); STARK, Wendelin, Jan, CH-4900 Langenthal (CH); FEDURCO, Milan, F-63040 Clermont-Ferrand Cedex 9 (FR); DELFINO, Antonio, F-63040 Clermont-Ferrand Cedex 9 (FR); MERALDI, Jean-Paul, CH-8049 Zurich (CH)
(74) Mandataire: Desbordes, Guillaume
(86) Numéro de dépôt international: PCT/EP2015/061168
(87) Numéro de publication internationale: WO 2015/193051

(56) Documents cités:
- DE-A1-102012 109 260

## Description

### 1. DOMAINE DE L'INVENTION

La présente invention est relative aux renforts métalliques ou métallisés, utilisables comme éléments de renforcement de matrices en polymère tel que par exemple du caoutchouc, notamment dans des bandages, pneumatiques ou non pneumatiques, pour véhicules.

Elle est plus particulièrement relative aux renforts dont la surface a été traitée en vue d'une part de les protéger contre la corrosion, d'autre part de permettre leur adhésion ultérieure à des matrices de polymères éthyléniquement insaturés tels que du caoutchouc naturel, ceci notamment sans que soit nécessaire l'emploi de sels de cobalt dans ces matrices de polymère.

### 2. ETAT DE LA TECHNIQUE

Les composites de type métal / caoutchouc, en particulier pour bandages, sont bien connus. Ils sont généralement constitués d'une matrice en caoutchouc insaturé généralement diénique, réticulable au soufre, comportant des éléments de renforcement (ou « renforts ») métalliques tels que des fils ou câbles en acier au carbone.

Soumis à des contraintes très importantes lors du roulage des bandages, notamment à des compressions, flexions ou variations de courbure répétées, ces composites doivent de manière connue satisfaire à un grand nombre de critères techniques, parfois contradictoires, tels qu'uniformité, flexibilité, endurance en flexion et en compression, résistance à la traction, à l'usure et à la corrosion, et maintenir ces performances à un niveau très élevé aussi longtemps que possible.

On comprend aisément que l'interphase adhésive entre le caoutchouc et ces renforts joue un rôle prépondérant dans la pérennité des performances ci-dessus.

Le procédé traditionnel pour relier les compositions de caoutchouc à de l'acier au carbone consiste à revêtir la surface de l'acier avec du laiton (alliage cuivre-zinc), la liaison entre l'acier et la matrice de caoutchouc étant assurée par sulfuration du laiton (formation de sulfures de zinc et de cuivre) lors de la vulcanisation (c'est-à-dire réticulation tridimensionnelle par le soufre) ultérieure de la matrice de caoutchouc. Ce processus de sulfuration se traduit en particulier par la formation in-situ de clusters métalliques à la surface du laiton appelés « dendrites », autour desquels on suppose que vient s'ancrer (par ancrage mécanique et chimique) la matrice de caoutchouc lors de la vulcanisation.

En outre, on incorpore généralement dans cette matrice de caoutchouc des sels organiques ou des complexes de cobalt en tant qu'additifs promoteurs d'adhésion. On sait que le cobalt participe activement non seulement au processus de vulcanisation du caoutchouc, mais encore à celui de dendritisation du laiton en s'incorporant dans les dendrites elles-mêmes (par formation de sulfures intermétalliques Cu-Zn-Co), selon des mécanismes complexes de réactions redox conduisant on le suppose à la corrosion du laiton, à la dissolution du métal et à son redépôt sous la forme de ces dendrites de sulfures métalliques (dendrites sulfurées). On pourra se reporter pour plus de détail à la publication RCT (Rubber Chemistry and Technology), vol. 78, pp 426-457, auteur W. Stephen Fulton, intitulée « Steel tire cord-rubber adhesion, including the contribution of cobalt »).

Toutefois, il est aussi connu que la présence de ces composés de cobalt dans les compositions de caoutchouc rend ces dernières plus sensibles à l'oxydation et au vieillissement, tant et si bien que l'adhésion entre l'acier au carbone et la matrice de caoutchouc est également susceptible de s'affaiblir au cours du temps du fait de l'évolution progressive des sulfures formés, sous l'effet des différentes sollicitations rencontrées, notamment mécaniques et/ou thermiques, le processus de dégradation ci-dessus pouvant être accéléré en outre en présence d'humidité.

Leur incorporation augmente aussi significativement le coût des compositions de caoutchouc, sans compter qu'il est souhaitable de supprimer à terme le cobalt de ces compositions, en raison de l'évolution récente de la réglementation européenne, cobalt et sels de cobalt étant considérés comme relativement toxiques pour l'environnement.

Pour toutes les raisons exposées ci-dessus, les fabricants de composites métal / caoutchouc, en particulier les manufacturiers de bandages sont à la recherche de solutions nouvelles pour protéger les renforts métalliques contre la corrosion, les faire coller aux compositions de caoutchouc, tout en palliant, au moins en partie, les inconvénients précités.

Parmi l'état de la technique doit être aussi cité le document US 2013/143067 décrivant un fil conducteur électrique, par exemple en cuivre ou nickel, sur lequel est déposée une couche de graphène. En outre, le fil peut être en acier ou aluminium, sur lequel est déposée une couche de graphène empêchant l'oxydation.

### 3. BREVE DESCRIPTION DE L'INVENTION

Or, au cours de leurs recherches, les Demanderesses ont trouvé un renfort nouveau répondant à l'objectif ci-dessus.

La présente invention concerne un renfort filiforme, métallique ou métallisé, tel qu'énoncé dans la revendication 1.

Ainsi, le renfort de l'invention est apte à renforcer directement cette matrice de polymère.

Les renforts selon l'invention présentent comme avantage majeur celui d'être protégés efficacement contre la corrosion, aussi de pouvoir ensuite être collés directement, c'est-à-dire sans primaire d'adhésion ni ajout de sel métallique (en particulier de sel de cobalt) à des matrices de caoutchouc insaturé tel que du caoutchouc naturel.

Si le dépôt d'un métal de surface est certes nécessaire, cette technologie est simplifiée par rapport à l'art antérieur (laitonnage pour collage au caoutchouc) car elle ne nécessite pas le dépôt à la fois de Cu et Zn, puis un traitement de thermodiffusion à haute température pour formation de laiton.

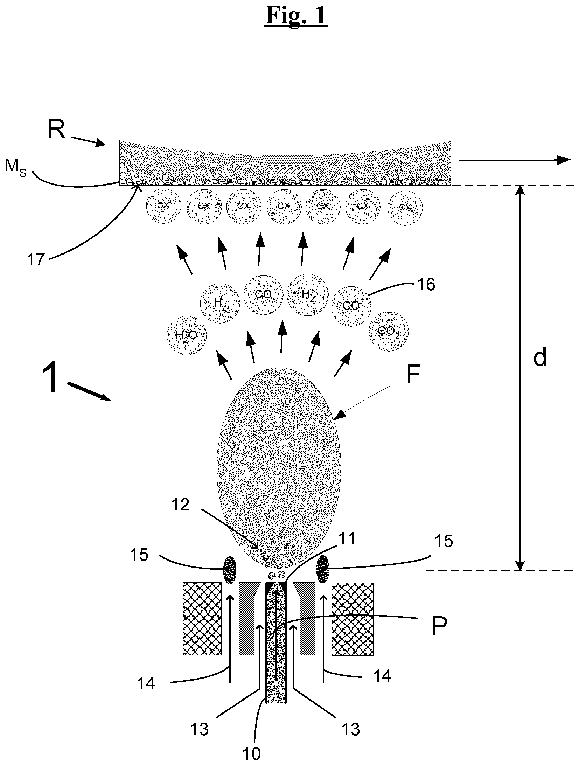

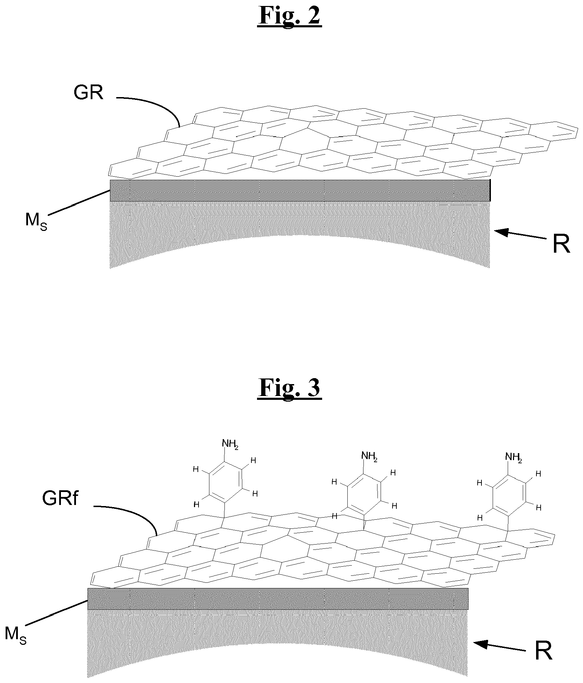

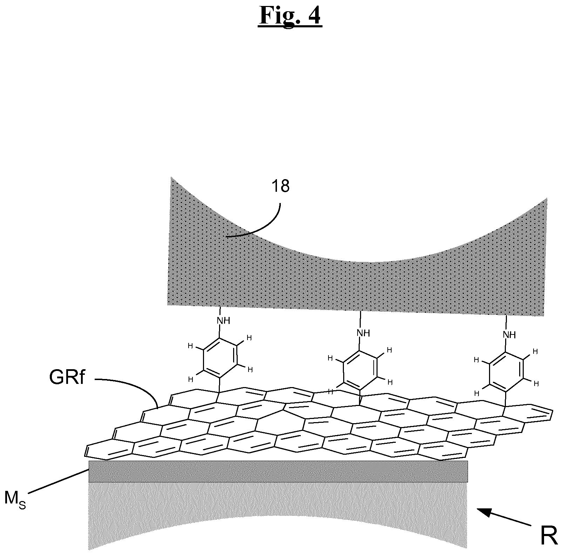

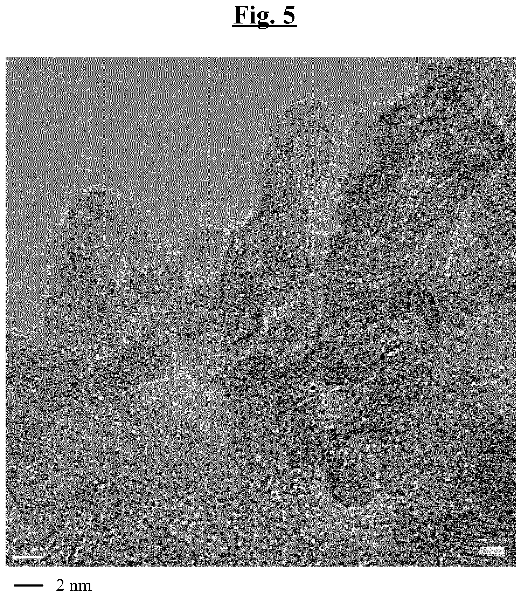

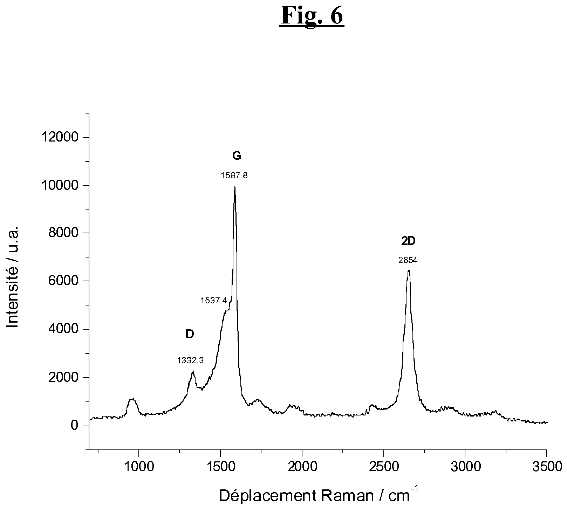

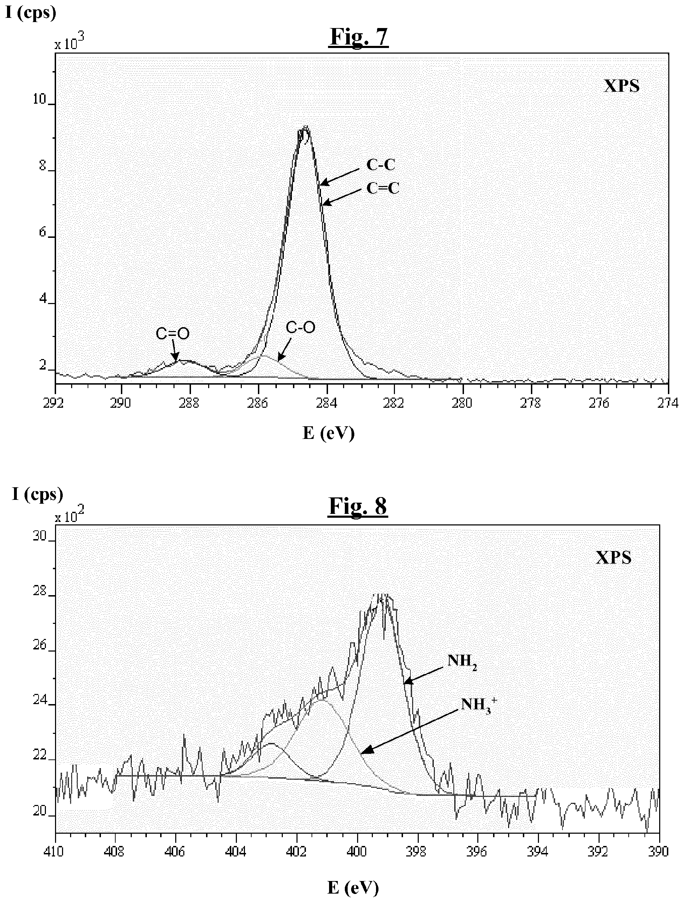

L'invention ainsi que ses avantages seront aisément compris à la lumière de la description détaillée et des exemples de réalisation qui suivent, ainsi que des figures relatives à ces exemples qui représentent ou schématisent :
- un schéma illustrant le principe d'un procédé permettant l'obtention d'un renfort selon l'invention, ainsi qu'un exemple de dispositif utilisable pour la mise en œuvre de ce procédé (Fig. 1) ;
- un schéma illustrant l'état de surface d'un renfort (R) une fois traité FSP, avec formation de graphène (GR) à la surface du métal de surface M_{S} (Fig. 2) ;
- un autre schéma illustrant l'état de surface du renfort (R) selon l'invention une fois graphénisé et fonctionnalisé, avec présence de graphène fonctionnalisé (GRf) à la surface du métal de surface M_{S} (Fig. 3) ;
- un schéma illustrant la réticulation, l'ancrage du graphène fonctionnalisé (GRf), après réaction de ses groupes fonctionnels, sur une matrice de polymère (18) (Fig. 4) ;
- une reproduction d'un cliché de MET réalisé sur un échantillon de graphène prélevé à la surface d'un renfort (Fig. 5) ;
- un spectre Raman enregistré sur un autre échantillon de graphène prélevé à la surface d'un renfort (Fig. 6) ;
- une reproduction d'un spectre XPS réalisé à la surface d'un renfort, après graphénisation, confirmant bien la présence de graphène (Fig. 7) ;
- une reproduction d'un autre spectre XPS réalisé à la surface d'un renfort selon l'invention, après graphénisation puis fonctionnalisation, confirmant bien la fonctionnalisation du graphène par des groupes amine NH₂ (Fig. 8).

### 4. DESCRIPTION DETAILLEE DE L'INVENTION

Dans la présente description, sauf indication expresse différente, les pourcentages (%) indiqués sont des pourcentages en masse.

D'autre part, tout intervalle de valeurs désigné par l'expression "entre a et b" représente le domaine de valeurs allant de plus de a à moins de b (c'est-à-dire bornes a et b exclues) tandis que tout intervalle de valeurs désigné par l'expression "de a à b" signifie le domaine de valeurs allant de a jusqu'à b (c'est-à-dire incluant les bornes strictes a et b).

L'invention concerne donc un renfort filiforme, métallique ou métallisé, à la périphérie duquel est disposée une couche de métal dit « métal de surface » choisi parmi le cuivre, le nickel et les alliages de cuivre-nickel ; cette couche de métal de surface est elle-même revêtue, au moins en partie, d'au moins une (c'est-à-dire une ou plusieurs) couche de graphène ; en outre, est greffé sur le graphène au moins un groupe fonctionnel réticulable à une matrice de polymère.

### 4.1 Renfort

Par renfort « filiforme » (*en anglais « threadlike »),* on entend de manière bien connue de l'homme du métier un renfort allongé, de très grande longueur par rapport à sa section, quelle que soit la forme de cette dernière, par exemple circulaire, oblongue, rectangulaire ou carrée, ou même plate, ce renfort du fait de sa grande longueur étant susceptible d'être enroulé en plusieurs spires sur une bobine de réception ou de stockage ; pour fixer les idées, le rapport de sa longueur sur la plus grande dimension de sa section transversale est typiquement supérieur à 10³, de préférence supérieur à 10⁴.

Ce renfort filiforme peut être rectiligne comme non rectiligne, par exemple torsadé, ou ondulé. L'épaisseur (cas d'une section droite non circulaire) de ce renfort, ou son diamètre lorsque sa section droite est de forme circulaire, est de préférence comprise entre 0,05 et 5 mm, plus préférentiellement entre 0,1 et 1 mm, en particulier entre 0,12 et 0,50 mm.

Selon un mode de réalisation particulier, le renfort filiforme est un fil unitaire ou un assemblage de fils tel que par exemple un câble, un retors ou encore un tissu, notamment un tissu croisé.

Selon un autre mode de réalisation particulier, le renfort filiforme est un ruban (par convention, ayant une largeur d'au plus 5 cm) ou un film (par convention, ayant une largeur supérieure à 5 cm), dont l'épaisseur, comme déjà indiqué supra, est comprise de préférence entre 0,05 et 5 mm, plus préférentiellement entre 0,1 et 1 mm, en particulier entre 0,12 et 0,50 mm.

Le renfort selon l'invention peut être métallique, c'est-à-dire entièrement métallique, à cœur comme à périphérie, ou encore simplement métallisé dans le cas d'un renfort hybride constitué de métal à sa périphérie et à cœur d'un moins un autre matériau non métallique. C'est ainsi que le renfort pourrait être textile, par exemple en aramide, en carbone ou en verre, mais métallisé à sa périphérie par dépôt d'un revêtement de métal, identique à ou différent du métal de surface M_{S} proprement dit.

De préférence, le renfort est un renfort entièrement métallique, à cœur comme à peau ou à périphérie.

Plus préférentiellement, le métal à cœur du renfort métallique est un acier, en particulier un acier au carbone, ce dernier pouvant être ou non revêtu d'un autre métal, optionnel, autre que le métal de surface M_{S}, disposé par conséquent entre l'acier et le métal de surface.

L'acier au carbone est préférentiellement tel qu'utilisé habituellement dans les câbles type *"steel cords"* pour pneumatiques ; mais il est bien entendu possible d'utiliser d'autres aciers, par exemple des aciers inoxydables. Lorsqu'un acier au carbone est utilisé, sa teneur en carbone est de préférence comprise entre 0,4% et 1,2%, notamment entre 0,5% et 1,1%. L'invention s'applique en particulier à tout acier du type *steel cord* à résistance standard (dit "NT" pour *" Normal Tensile "*), à haute résistance (dit "HT" pour *" High Tensile "*), à très haute résistance (dit "SHT" pour " *Super High Tensile "*) comme à ultra-haute résistance (dit "UHT" pour *"Ultra High Tensile "*).

Lorsque l'acier, notamment acier au carbone, ci-dessus est revêtu, au moins en partie, d'un métal dit « métal substrat » ou « métal de revêtement », servant par conséquent de substrat à la couche du métal de surface M_{S}, le métal substrat est de préférence choisi dans le groupe constitué par l'aluminium, le cobalt, l'étain, le manganèse, le molybdène, le zinc, et les alliages comportant au moins un de ces éléments, plus préférentiellement choisi dans le groupe constitué par le cobalt, le zinc, et les alliages comportant au moins un de ces éléments ; ce métal substrat, optionnel, peut être notamment du laiton.

### 4.2 Couche de métal de surface M_{S}

Une caractéristique essentielle commune à tous les renforts selon l'invention, est qu'ils sont pourvus à leur périphérie, préalablement au dépôt de graphène, d'une couche de métal dit « métal de surface » (métal noté « M_{S} ») sur laquelle est déposé le graphène.

Ce métal M_{S} est choisi parmi le cuivre, le nickel et les alliages de cuivre et de nickel ; préférentiellement, il s'agit de cuivre.

La couche de métal M_{S} a une épaisseur qui est de préférence comprise entre 0,1 et 10 µm, plus préférentiellement entre 0,5 et 5 µm. Elle peut être déposée par tout moyen connu de l'homme du métier, par exemple par voie électrochimique ou chimique.

### 4.3 Graphénisation

Le renfort de l'invention a pour caractéristique essentielle que son métal de surface est revêtu d'au moins une (c'est-à-dire une ou plusieurs) couche de graphène.

Il est obtenu par exemple et de manière préférentielle par un procédé consistant à déposer, au défilé, au moins une couche de graphène sur la surface d'un renfort continu métallique ou métallisé, à la périphérie duquel est disposée une couche de métal dit « métal de surface » choisi parmi le cuivre, le nickel et les alliages de cuivre-nickel, ledit procédé comportant au moins une étape de pyrolyse par projection de flamme, sous atmosphère réductrice, d'un précurseur de carbone générant dans la flamme au moins un gaz carboné qui est projeté à la surface du renfort métallique en cours de défilement, et s'y décompose pour former ladite couche de graphène à la surface du métal de surface.

Le terme « au défilé » signifie bien entendu que le renfort continu est en déplacement relatif dans la direction de son axe.

Ce traitement de surface a donc pour caractéristique essentielle de comporter une étape de pyrolyse par projection de flamme, en abrégé « FSP » (pour *Flame Spray Pyrolysis*), d'un précurseur de carbone générant dans la flamme au moins un gaz carboné.

Le gaz carboné formé, de préférence du monoxyde de carbone (CO), est propulsé, projeté par la flamme vers la surface du corps à traiter, d'où le nom attribué à cette technologie.

La pyrolyse par projection de flamme est une méthode aujourd'hui bien connue, qui a été essentiellement développée pour la synthèse de poudres ultrafines d'oxydes simples ou mixtes de divers métaux (e.g. SiO₂, Al₂O₃, B₂O₃, ZrO₂ GeO₂, WO₃, Nb₂O₅, SnO₂, MgO, ZnO, CeₓZr₍₁₋ₓ₎O₂), à morphologies contrôlées, et/ou leur dépôt sur divers substrats, ceci en partant d'une grande variété de précurseurs métalliques, généralement sous la forme de liquides pulvérisables, organiques ou inorganiques, de préférence inflammables ; les liquides pulvérisés dans la flamme, en se consumant, émettent notamment des nanoparticules d'oxydes métalliques qui sont projetées par la flamme elle-même sur ces divers substrats.

Le principe de cette méthode a été rappelé par exemple dans la publication récente (2011) de Johnson Matthey intitulée « Flame Sray Pyrolyzis : a Unique Facility for the Production of Nanopowders », Platinum Metals Rev., 2011, 55, (2), 149-151. De nombreuses variantes de procédés et réacteurs FSP ont été décrits également, à titre d'exemples, dans les brevets ou demandes de brevet US 5 958 361, WO 01/36332 ou US 6 887 566, WO 2004/005184 ou US 7 211 236, WO 2005/103900, WO 2007/028267 ou US 8 182 573, WO 2008/049954 ou US 8 231 369, US 2009/0123357, US 2009/0126604, US 2010/0055340, WO 2011/020204.

Toutefois, à la connaissance des Demanderesses, la méthode FSP n'avait jamais été utilisée à ce jour pour la graphénisation en continu de renforts métalliques ou métallisés, ces renforts étant en particulier pourvus de la couche de métal de surface M_{S} décrite précédemment.

Par « précurseur de carbone» ou « précurseur de gaz carboné », apte à générer lors de sa combustion dans la flamme au moins un gaz carboné, en particulier et de préférence du monoxyde de carbone (CO), on entend dans la présente demande le produit qui est projeté dans la flamme, quelle que soit la forme ou la présentation de ce produit. Il peut être solide (par exemple sous forme de poudre, projeté et fondu directement dans la flamme), liquide ou encore gazeux, à la température ambiante (20°C) ; de préférence, il est liquide ou gazeux.

Selon un mode de réalisation plus préférentiel, le précurseur de carbone est gazeux; il est par exemple choisi dans le groupe constitué par le méthane, l'éthane, le propane, l'acétylène, l'éthylène et leurs mélanges.

Selon un autre mode de réalisation plus préférentiel, le précurseur de carbone est liquide ; il s'agit plus préférentiellement d'un solvant aromatique liquide à température ambiante, en particulier du type inflammable ; on citera notamment ceux choisis dans le groupe constitué par benzène, toluène, xylène, naphtalène, tétrahydrofurane, acide éthylhexanoïque et les mélanges de tels composés.

Le traitement FSP peut être conduit à toute température, bien entendu inférieure aux températures de fusion du renfort (ou d'un de ses éléments constitutifs) et de son métal de surface M_{S}. Pour optimiser la durée et l'efficacité du traitement, la température du métal de surface M_{S}, pendant la graphénisation, est préférentiellement comprise entre 300°C et 600°C, de préférence entre 400°C et 550°C.

La figure 1 annexée illustre de manière très schématique, sans respect d'une échelle spécifique, le principe d'un procédé FSP (pyrolyse par projection de flamme) utilisable pour la fabrication du renfort de l'invention ainsi qu'un exemple de dispositif (1) utilisable pour la mise en œuvre de ce procédé.

Le principe de la méthode est d'injecter un précurseur donneur de carbone (P) puis de le pulvériser dans une flamme (F) à l'aide d'un gaz propulseur et oxydant ; la combustion du précurseur (P) dans la flamme (F) permet la formation de l'espèce visée (ici, un gaz carboné).

Le dispositif 1 de cet exemple comporte essentiellement trois alimentations respectives :
- des moyens d'atomisation (10, 11), comportant au moins un capillaire (10) et une buse (11) d'alimentation en combustible ou précurseur (P), par exemple sous forme liquide ou gazeuse, dont la fonction est d'éjecter, pulvériser le précurseur, par exemple sous la forme de fines gouttelettes (12), la forme du jet étant dictée par les conditions particulières d'atomisation ; ces moyens d'atomisation (10, 11) sont bien entendu précédés d'une pompe de dimensionnement adapté (dans les exemples qui suivent, une micropompe volumétrique rotative gérotor, modèle « mzr-2905 » de la société HNP Mikrosysteme GmbH), non représentée sur cette figure pour simplification ;
- une alimentation en gaz d'oxydation (13) (à l'aide d'une pompe non représentée sur le schéma) éjectant le gaz oxydant dans la zone de sortie de la buse d'alimentation (11), dont la fonction est d'une part de propulser les gouttelettes (12) dans la flamme (F), d'autre part d'oxyder le précurseur (P) pour le transformer en gaz carboné ;
- enfin une alimentation en gaz support (gaz d'allumage et de combustion) (14), par exemple un mélange de méthane et d'oxygène, alimentant deux petites flammes (flammes secondaires) (15) destinées quant à elles à enflammer les gouttelettes (12) de précurseur (P) pour formation de la flamme principale (F).

C'est donc la flamme (F) générée par le gaz de combustion (14) et le gaz oxydant (13) qui constitue le réacteur FSP, réacteur thermique à très haute température puisque la température à l'intérieur de la flamme (F), selon les conditions opératoires préférentielles données ci-dessus, est supérieure à 300°C, par exemple comprise entre 300°C et 600°C.

C'est la combustion dans la flamme (F) du précurseur (P) en présence d'oxygène (13), qui va générer le gaz carboné (16) visé, ainsi que d'autres espèces gazeuses selon la nature particulière du précurseur utilisé, ces espèces étant de préférence réductrices comme expliqué plus en détail ci-après.

L'homme du métier comprendra que le traitement FSP est ici mis en œuvre dans une atmosphère « pauvre en oxygène » (conditions dites de « flamme réductrice » ou « atmosphère réductrice »), c'est-à-dire avec le minimum d'oxygène nécessaire (on tend vers une combustion incomplète), sans quoi il n'y aurait pas formation de gaz carboné (et d'autres espèces gazeuses réductrices) ; de préférence, le taux d'oxygène dans la chambre de combustion (mesuré immédiatement en sortie de chambre) est inférieur à 200 ppm, en particulier compris dans un domaine de 5 à 200 ppm, de préférence inférieur à 100 ppm, en particulier compris dans un domaine de 10 à 100 ppm. La totalité de la chambre de combustion (dans les exemples qui suivent, une simple boîte à gants fermée, aménagée) est donc balayée par un courant de gaz inerte tel que de l'azote. La hauteur de la flamme principale (F) est typiquement comprise entre 5 et 10 cm.

La flamme est placée, en fonction de l'intensité du traitement désirée, à une distance variable de la surface (17) du métal de surface M_{S} à traiter, distance que l'homme du métier pourra aisément définir en fonction des conditions particulières de mise en œuvre de l'invention. Cette distance notée « d » sur la figure 1, mesurée entre la base de la flamme (F) et la surface (17) du métal M_{S} est de préférence comprise entre 30 et 100 mm, de préférence entre 50 et 80 mm, en particulier entre 55 et 75 mm.

C'est la flamme (F), grâce à son énergie cinétique, qui sert de propulseur du gaz carboné (16) vers la surface (17) du métal M_{S} à traiter.

Sans être lié à cette théorie, on peut supposer *a posteriori* que le gaz carboné (CO), produit dans la flamme, est ensuite hydrogéné pour former des espèces carbonées intermédiaires (notées symboliquement « CX » sur la fig. 1) qui interagissent à leur tour, sur la surface du métal de surface M_{S}, pour former le graphène (en une ou plusieurs couches).

La durée du traitement de graphénisation est typiquement de quelques dixièmes de seconde à quelques secondes, en fonction des conditions particulières de mise en œuvre du procédé, en particulier selon la vitesse de défilement du renfort, de la distance « d » et de la température de la flamme. A titre d'exemple, la vitesse de défilement du renfort est comprise entre 0,5 cm/s et 50 cm/s, en particulier entre 1 et 5 cm/s.

Les installations utilisables pour la mise en œuvre d'un tel procédé ne sont bien entendu pas limitées aux exemples et modes de réalisation décrits ci-dessus.

Pour traiter, en particulier à vitesse élevée, des quantités importantes de renforts tels que fils, câbles, rubans ou films, les installations utilisées pourraient bien entendu comporter une combinaison de plusieurs flammes disposées en ligne et/ou en parallèle, ce qui constitue un avantage majeur de la présente invention. Pour accélérer le traitement, les renforts pourraient être également préchauffés par passage à travers des moyens de chauffage tels que des fours, ou encore chauffés par effet Joule par passage d'un courant électrique à travers les renforts lors de leur traitement de graphénisation.

Ainsi, et de manière tout à fait inattendue, par « simple » passage dans une flamme de composition appropriée, il s'est avéré possible de graphéniser en continu des renforts métalliques ou métallisés, et de les protéger ainsi efficacement leur surface, notamment contre la corrosion.

La figure 2 représente de manière très schématique l'état de surface d'un renfort R et de son métal de surface M_{S} une fois qu'il a été traité FSP comme indiqué précédemment.

Pour rappel, le graphène est une monocouche de carbone, sous la forme de noyaux benzéniques condensés ensemble ; il a été typiquement produit dans le passé à partir de graphite par exfoliation mécanique. C'est un cristal bidimensionnel (monoplan) de carbone (système cristallin hexagonal) ; chaque couche de graphène, d'épaisseur égale à environ 0,4 nm (nanomètre), consiste essentiellement en des atomes de carbone hybridés sp².

De préférence, conformément à l'invention, le renfort R comporte 1 à 5 couches, plus préférentiellement 2 à 4 couches de graphène.

Pour fixer les idées, au microscope optique, une monocouche de graphène absorbe environ 1 à 3% de la lumière visible. Si l'on dépose le graphène total (sous forme de « feuille » comportant des couches superposées) sur un support transparent, après l'avoir séparé du renfort R, par exemple par une dissolution chimique du métal de surface M_{S}, on sait que l'œil humain voit à travers la feuille de graphène jusqu'à un nombre de couches de graphène égal à 4. A partir de 5 couches, la feuille de graphène apparaîtra noire.

Selon l'invention, le renfort graphénisé précédemment décrit est traité en vue de greffer sur le graphène au moins un groupe fonctionnel réticulable à une matrice de polymère, rendant ainsi le renfort de l'invention apte à renforcer directement cette matrice de polymère.

### 4.4 Fonctionnalisation du graphène

Une fois le renfort graphénisé (traité FSP), ce dernier est traité, toujours au défilé, en vue de greffer sur le graphène, de préférence sur la couche la plus externe si plusieurs couches de graphène sont présentes, au moins un groupe fonctionnel réticulable à la matrice de polymère qu'il est destiné à renforcer, de manière à rendre ainsi ledit renfort apte à adhérer par réticulation à cette matrice de polymère.

Le polymère peut être éthyléniquement insaturé ou pas, la réticulation pouvant se faire sur le polymère insaturé, ou bien sur des composants de la matrice de polymère autres que le polymère lui-même.

Le renfort de l'invention est préférentiellement un renfort métallique destiné à adhérer ultérieurement à une matrice de caoutchouc éthyléniquement insaturé tel qu'un élastomère diénique, pour constituer un composite métal / caoutchouc tel que ceux usuellement rencontrés dans les articles en caoutchouc tels que des bandages pour véhicules automobiles. Le groupe fonctionnel peut être par exemple du type vulcanisable, c'est-à-dire réticulable par l'intermédiaire de ponts de soufre.

Préférentiellement, le groupe fonctionnel réticulable comporte au moins une fonction notée « FG » (Fonction Graphène) choisie parmi les fonctions - NH₂, - NHR (R radical hydrocarboné), -OH, - COOH, -CHO, - SH, -Sₓ- (polysulfure, « x » supérieur à 1), halogènes (notamment -Cl, -Br, -F), acrylate, méthacrylate, époxy, vinyle, vinyloxy, isocyanate.

Selon un mode de réalisation plus préférentiel, le groupe fonctionnel réticulable comportant la fonction « FG », répond à la formule : 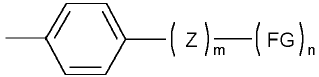 dans laquelle :
- « m » est égal à 0 ou à 1 ;
- « n » est un entier de 1 à 5 ;
- Z est un groupement de liaison, optionnel, au moins divalent (séparateur ou « *spacer »*) ; à titre d'exemples peuvent être cités une liaison éther - O -, une liaison thioéther - S -, un groupement hydrocarboné aliphatique, cycloaliphatique ou aromatique, comportant de préférence de 1 à 20 atomes de carbone et pouvant comporter un hétéroatome.

Selon un mode de réalisation encore plus préférentiel, le groupe fonctionnel réticulable comportant la fonction « FG » (ici fonction amine primaire - NH₂), répond à la formule particulière qui suit :

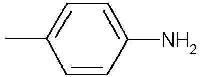

La fonctionnalisation du graphène, c'est-à-dire le greffage sur le graphène de groupes fonctionnels comportant au moins une fonction « FG » telle que décrite ci-dessus, pourra être conduite par tout moyen connu, par exemple par immersion, en particulier au défilé, dans un bain liquide de formulation appropriée.

Ce bain liquide est par exemple un bain d'une solution aqueuse contenant au moins un sel diazonium de formule : 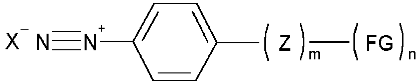 dans laquelle Z, FG, « m » et « n » ont les définitions déjà données et X⁻ représente l'anion du sel, par exemple du chlore.

En particulier, ce sel diazonium a pour formule :

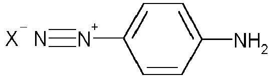

La figure 3 représente de manière très schématique l'état de surface du renfort R et de son métal de surface M_{S} une fois traité FSP, c'est-à-dire graphénisé, puis la couche la plus externe de graphène fonctionnalisée (graphène noté « GRf » sur la figure) par traitement dans un bain aqueux du sel diazonium ci-dessus.

Enfin, la figure 4 est un schéma illustrant de manière très simple la réticulation, l'ancrage du graphène fonctionnalisé (GRf) après réaction de ses groupes fonctionnels (FG) sur une matrice de polymère (18) tel que par exemple du caoutchouc naturel époxydé dont les fonctions époxy ont réagi avec les fonctions -NH₂ de la couche de graphène la plus externe.

### 5. EXEMPLES DE REALISATION DE L'INVENTION

### 5.1 Essai 1 - Graphénisation par FSP

Lors de ce premier essai, un fil en acier au carbone laitonné (Cu/Zn : 60/40) a été soumis à un traitement FSP pour l'obtention d'un renfort graphénisé, ce procédé étant mis en œuvre à l'aide du dispositif schématisé à la figure 1 (boîte à gants fermée balayée par un courant d'azote) dans une atmosphère pauvre en oxygène (teneur en O₂ dans la chambre de combustion, mesurée immédiatement en sortie de chambre, inférieure à 10 ppm).

Préalablement, ce fil de diamètre égal à environ 0,30 mm (épaisseur de la couche de laiton comprise entre 200 et 500 nm) avait été nettoyé par passage dans une solution aqueuse à 1% de NH₃, rincé à l'eau distillée et séché, le tout sous courant d'azote (de préférence à l'abri de l'air pour éviter une ré-oxydation).

Puis ce fil en tant que cathode (-0,5 V par rapport à une électrode de référence Ag/AgCl) a été soumis à une étape de cuivrage de surface par voie électrolytique, par traitement d'environ 5 s dans un bain contenant 2 g de pyrophosphate de cuivre hydraté (Aldrich, #34,469-9) et une solution à 85% d'acide phosphorique dans de l'eau. On a obtenu ainsi un dépôt final d'une couche de métal de surface M_{S} (Cuivre) uniforme, d'une épaisseur égale à environ 3 µm, comme attesté par des analyses par MEB (microscopie électronique à balayage) et par EDS (*Energy Dispersive Spectrometry*), protégeant ainsi parfaitement le fil ci-dessus de la corrosion : des tests d'immersion (15 s) dans un bain aqueux (solution d'eau distillée à 100°C) de thiosulfate de sodium (Na₂S₂O₃ ; 5 g/l) et de nitrate de fer III (Fe(NO₃)₃ ; 60 g/l) ont révélé en effet l'absence de changement de couleur sur le fil ainsi cuivré alors qu'un fil témoin (non cuivré) présentait un fort noircissement en surface dû à sa corrosion.

Puis le fil ainsi cuivré, piloté par un automate, a été envoyé à travers un réacteur FSP à une vitesse d'environ 10 mm/s et à une distance « d » de la flamme (F) égale à environ 70 mm. La chambre de combustion (1) était ici alimentée en continu par environ 5 ml/min de précurseur P liquide (mélange de 34% de THF et 66% d'acide 2-éthylhexanoïque), 5 l/min d'oxygène (gaz d'oxydation 13) et un mélange de méthane et d'oxygène (gaz support 14) (CH₄ : 1,5 ml/min ; O₂ : 2,4 ml/min). La hauteur de la flamme (F) était comprise entre 6 et 7 cm, la température à l'intérieur de la flamme était égale à environ 500°C.

Dans le présent exemple de réalisation, et pour les diverses conditions opératoires ci-dessus, la combustion et l'oxydation du précurseur (P) a conduit à une composition gazeuse, mesurée immédiatement en sortie de chambre par spectrométrie de masse (« Pfeiffer Quadstar 100 ») qui était la suivante (% molaire) : 1% de H₂O, 1% de H₂, 0,5% de CO₂, moins de 100 ppm de O₂ ; par ailleurs, la flamme produisant suffisamment de CO, aucune addition d'un tel gaz n'a été nécessaire.

La figure 5 annexée reproduit un cliché de microscope électronique à transmission à très haute résolution (TEM-FEG de la société FEI ; puissance 300 kV ; grossissement 620 000) réalisé sur un échantillon de graphène prélevé à la surface du fil selon l'invention ainsi traité, par une dissolution complète (durant toute la nuit) du métal de surface M_{S} dans une solution aqueuse (6 ml par échantillon de graphène) de FeCl₃ (1 M) ; cette solution devenue rougeâtre a été ensuite progressivement (en 5 fois), lentement, remplacée par de l'eau jusqu'à obtention d'une solution limpide, en évitant de retirer la totalité de la solution ainsi que tout contact avec le graphène, ce processus laissant in fine flotter librement à la surface de l'eau une feuille très fine de graphène.

Sur ce cliché de la figure 5, une distance de 7 mm représente 2 nm ; ce cliché révèle bien les atomes de carbone (sous forme d'un réseau hexagonal) de la feuille de graphène prélevée, cette feuille se présentant ici sous la forme de monocouches superposées dont le nombre est estimé égal à 1 à 3, selon la partie de cliché considérée.

La figure 6 reproduit quant à elle un spectre Raman (spectroscope micro-Raman confocal « CRM 200 » de la société Witec) enregistré à 532 nm (excitation 2,33 eV ; laser YAG-Nd) sur un autre échantillon (feuille) de graphène prélevé à la surface du fil traité FSP comme indiqué ci-dessus, et déposé sur une plaquette (*« wafer »*) de silicium. En ordonnée, est indiquée l'intensité du signal (en unités arbitraires) et en abscisse le déplacement Raman (en cm⁻¹).

Ce spectre est la signature typique de graphène, distinguant en particulier clairement ce dernier du graphite ; la forme et la position des deux pics à environ 1588 cm⁻¹ et 2654 cm⁻¹ confirment bien en effet la présence de graphène sous forme hybridé sp².

Plus précisément, le pic très étroit à 1587,8 cm⁻¹ (bande G) avec une largeur à mi-hauteur d'environ 30 cm⁻¹, correspond à une monocouche de graphène. L'autre pic (bande 2D) à 2654 cm⁻¹, fortement déplacé vers le bleu, avec une largeur à mi-hauteur de 60 cm⁻¹ correspond plutôt à deux monocouches de graphène superposées. Le ratio d'intensités I_{G}/I_{2D} supérieur à 1 s'explique par une résonance augmentée de la bande G causée par un fort couplage entre 2 couches de graphène orientées différemment, comme on peut déjà le percevoir par l'analyse MET précédente (Fig. 5).

Pour l'analyse et l'identification de graphène par spectroscopie Raman, l'homme du métier pourra se reporter utilement aux publications suivantes :
- Y.Y. Wang, Z.H. Ni, T. Yu, Z.X. Shen, H.M. Wang, Y.H. Wu, W. Chen & A.T.S. "Raman Studies of Monolayer Graphene: The substrate effect"; J. Phys. Chem. C 2008, 112, 10637-10640;
- K. Kim, S. Coh, L.Z. Tan, W. Regan, J.M. Youk, E. Chatterjee, M.F. Crommie, M.L. Cohen, S.G. Louie & A. Zettl. "Raman spectroscopy Study of Rotated Double-Layer Graphene: Misorientation-Angle Dependence of Electronic Structure"; Phys. Rev. Lett. 2012, 108, 246103, 1-6.

Enfin, la figure 7 reproduit un spectre XPS (*X-ray photoelectron spectroscopy*) (équipement Axis Ultra de la société Kratos ; source rayons X : Al Kα monochromatique (1486,6 eV), 10 mA, 15 kV ; ultravide inférieur à 10⁻⁸ Torr) réalisé à la surface du renfort avec, en ordonnée, l'intensité relative du signal (en coups/s) et, en abscisse, l'énergie de liaison (en eV). De manière connue, ce type d'analyse permet d'accéder à la composition chimique de la surface du matériau analysé sur une profondeur de quelques nanomètres, par comparaison avec des spectres connus.

Le pic principal observé à environ 284,6 eV est en fait la superposition de deux pics très voisins, le premier à environ 284,3 eV typique de liaisons C=C, et le second à environ 285,1 typique de liaisons C-C, le tout attestant bien la présence de graphène (graphène hybridé sp²) à la surface du métal de surface M_{S} (cuivre).

### 5.2 Essai 2 - Fonctionnalisation du graphène

Dans 250 ml d'eau, on a ajouté 0,2 g de p-phénylène-diamine et 0,2 g de nitrite de sodium, puis 0,5 ml d'acide chlorhydrique (à 36%), pour formation du sel diazonium de formule décrite précédemment (X représentant dans cet exemple l'anion Cl⁻) :

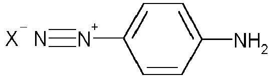

Puis un échantillon du fil graphénisé précédent a été soumis à une fonctionnalisation (amination) du graphène par immersion pendant 2 min dans la solution aqueuse ci-dessus agitée à l'aide d'un barreau aimanté. Le fil ainsi traité a été ensuite extrait de la solution, rincé abondamment à l'eau, puis séché sous courant d'azote.

La figure 8 reproduit le spectre XPS réalisé à la surface du renfort graphénisé puis fonctionnalisé, conforme à l'invention. Ce spectre confirme bien la fonctionnalisation du graphène, les deux pics principaux observés après déconvolution (91% de la surface totale des 3 pics visibles) étant typiques de la présence d'azote. Le pic d'intensité la plus élevée, à environ 399 eV, révèle en particulier la présence, en quantité importante, de fonctions NH₂ attachées à un noyau aromatique.

### 5.3 Essai 3 - Réticulation à une matrice de polymère

Enfin, des tronçons du fil en acier au carbone ainsi traité FSP, une fois recouvert de graphène puis le graphène fonctionnalisé, ont été disposés en sandwich entre deux couches d'une composition de caoutchouc pour formation d'un stratifié multicouches.

Cette composition de caoutchouc conventionnelle, pour armature de ceinture de pneumatique tourisme, était à base d'élastomère diénique (caoutchouc naturel) époxydé (taux d'époxydation d'environ 25% mol), de noir de carbone et silice à titre de charge, et d'un système de vulcanisation (soufre et accélérateur sulfénamide) ; cette composition étant dépourvue de sel de cobalt.

Puis l'éprouvette de composite métal / caoutchouc ainsi préparée a été placée sous presse et le tout cuit à 165°C pendant 30 min sous une pression de 20 bar.

Après vulcanisation du caoutchouc, on a obtenu un excellent collage entre la matrice de caoutchouc et le renfort métallique selon l'invention, malgré l'absence de sel de cobalt dans la matrice de caoutchouc : lors de tests de pelage conduits à température ambiante (20°C), on a constaté en effet que la rupture se produisait systématiquement dans la matrice de caoutchouc elle-même et non à l'interface entre métal (graphénisé) et caoutchouc.

Lors d'essais comparatifs, conduits dans les mêmes conditions (pas de sel de cobalt dans la matrice de caoutchouc) sur un fil métallique équivalent mais dépourvu sur son métal de surface M_{S} de graphène fonctionnalisé, on a constaté que le renfort métallique ne collait pas du tout au caoutchouc.

En conclusion, les renforts conformes à l'invention peuvent être protégés efficacement contre la corrosion grâce au graphène présent à leur surface ; avantageusement, ils peuvent être collés directement, sans primaire d'adhésion ni ajout de sel métallique (en particulier de sel de cobalt) à des matrices de caoutchouc insaturé tel que du caoutchouc naturel, grâce à la fonctionnalisation possible de ce graphène.

## Revendications

1. Renfort filiforme, métallique ou métallisé (R), à la périphérie duquel est disposée une couche de métal (Ms) dit « métal de surface » choisi parmi le cuivre, le nickel et les alliages de cuivre-nickel, dans lequel cette couche de métal de surface (Ms) est elle-même revêtue, au moins en partie, d'au moins une couche de graphène (GR, GRf), **caractérisé en ce qu'**est greffé sur le graphène au moins un groupe fonctionnel réticulable à une matrice de polymère.

2. Renfort selon la revendication 1, sous la forme d'un fil unitaire, d'un assemblage de fils, d'un ruban ou d'un film.

3. Renfort selon l'une quelconque des revendications 1 ou 2, dans lequel le métal de surface est du cuivre.

4. Renfort selon l'une quelconque des revendications 1 à 3, dans lequel le renfort est un renfort entièrement métallique.

5. Renfort selon la revendication 4, dans lequel le métal à cœur du renfort métallique est un acier, de préférence un acier au carbone.

6. Renfort selon la revendication 5, dans lequel l'acier est revêtu au moins en partie d'un métal dit « métal substrat » servant de substrat à la couche du métal de surface.

7. Renfort selon la revendication 6, dans lequel le métal substrat est choisi dans le groupe constitué par l'aluminium, le cobalt, l'étain, le manganèse, le molybdène, le zinc, et les alliages comportant au moins un de ces éléments.

8. Renfort selon la revendication 7, dans lequel le métal substrat est choisi dans le groupe constitué par le cobalt, le zinc, et les alliages comportant au moins un de ces éléments.

9. Renfort selon la revendication 8, dans lequel le métal substrat est du laiton.

10. Renfort selon l'une quelconque des revendications 1 à 9, l'épaisseur du renfort, ou son diamètre lorsque sa section droite est de forme circulaire, étant compris entre 0,05 et 5 mm, de préférence entre 0,1 et 1 mm.

11. Renfort selon l'une quelconque des revendications 1 à 10, dans lequel le nombre de couches de graphène varie de 1 à 5, de préférence de 2 à 4.

12. Renfort selon l'une quelconque des revendications 1 à 11, dans lequel le groupe fonctionnel réticulable comporte au moins une fonction notée « FG » choisie parmi les fonctions - NH₂, - NHR (R radical hydrocarboné), - OH, - COOH, - CHO, - SH,-Sₓ - (polysulfure, avec « x » supérieur à 1), halogènes, acrylate, méthacrylate, époxy, vinyle, vinyloxy, isocyanate.

13. Renfort selon la revendication 12, dans lequel le groupe fonctionnel réticulable répond à la formule : 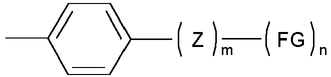 dans laquelle :
- « m » est égal à 0 ou à 1 ;
- « n » est un entier de 1 à 5.
- Z est un groupement de liaison, optionnel, au moins divalent.

14. Renfort selon la revendication 13, dans lequel le groupe fonctionnel réticulable répond à la formule :

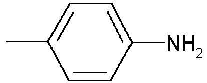

## Patentansprüche

1. Fadenförmige, metallische oder metallisierte Verstärkung (V), auf deren Umfang eine als "Oberflächenmetall" bezeichnete Metallschicht (Ms), ausgewählt aus Kupfer, Nickel und Kupfer-Nickel-Legierungen, abgeschieden ist, wobei diese Oberflächenmetallschicht (Ms) selbst zumindest zum Teil mit mindestens einer Graphenschicht (GR, GRf) beschichtet ist, **dadurch gekennzeichnet, dass** auf das Graphen mindestens eine mit einer Polymermatrix vernetzbare funktionelle Gruppe gepfropft ist.

2. Verstärkung nach Anspruch 1 in Form eines einzelnen Fadens, einer Gruppe von Fäden, eines Bandes oder einer Folie.

3. Verstärkung nach einem der Ansprüche 1 oder 2, wobei das Oberflächenmetall Kupfer ist.

4. Verstärkung nach einem der Ansprüche 1 bis 3, wobei die Verstärkung eine vollständig metallische Verstärkung ist.

5. Verstärkung nach Anspruch 4, wobei das Kernmetall der metallischen Verstärkung ein Stahl, vorzugsweise ein Kohlenstoffstahl, ist.

6. Verstärkung nach Anspruch 5, wobei der Stahl zumindest zum Teil mit einem als "Substratmetall" bezeichneten Metall beschichtet ist, das als Substrat für die Oberflächenmetallschicht dient.

7. Verstärkung nach Anspruch 6, wobei das Substratmetall aus der Gruppe ausgewählt ist bestehend aus Aluminium, Kobalt, Zinn, Mangan, Molybdän, Zink und Legierungen, die mindestens eines dieser Elemente enthalten.

8. Verstärkung nach Anspruch 7, wobei das Substratmetall aus der Gruppe ausgewählt ist bestehend aus Kobalt, Zink und Legierungen, die mindestens eines dieser Elemente enthalten.

9. Verstärkung nach Anspruch 8, wobei das Substratmetall Messing ist.

10. Verstärkung nach einem der Ansprüche 1 bis 9, wobei die Dicke der Verstärkung oder ihr Durchmesser, wenn ihr Querschnitt rund ist, zwischen 0,05 und 5 mm, vorzugsweise zwischen 0,1 und 1 mm, beträgt.

11. Verstärkung nach einem der Ansprüche 1 bis 10, wobei die Anzahl der Graphenschichten von 1 bis 5, vorzugsweise von 2 bis 4, variiert.

12. Verstärkung nach einem der Ansprüche 1 bis 11, wobei die vernetzbare funktionelle Gruppe mindestens eine als "FG" bezeichnete Funktion, ausgewählt aus den Funktionen -NH₂, -NHR (R Kohlenwasserstoffrest), -OH, - COOH, -CHO, -SH, -Sₓ- (Polysulfid, wobei "x" größer als 1 ist), Halogenen, Acrylat, Methacrylat, Epoxy, Vinyl, Vinyloxy, Isocyanat, umfasst.

13. Verstärkung nach Anspruch 12, wobei die vernetzbare funktionelle Gruppe der folgenden Formel entspricht: 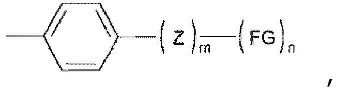 worin:
- "m" gleich 0 oder 1 ist,
- "n" eine ganze Zahl von 1 bis 5 ist,
- Z eine optionale, mindestens divalente Verbindungsgruppe ist.

14. Verstärkung nach Anspruch 13, wobei die vernetzbare funktionelle Gruppe der folgenden Formel entspricht:

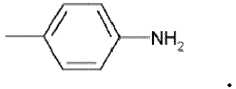

## Claims

1. Threadlike metal or metallized reinforcer, at the periphery of which is positioned a layer of metal referred to as "surface metal" (Ms) chosen from copper, nickel and copper/nickel alloys, in which said surface metal layer (Ms) is itself coated, at least in part, with at least one layer of graphene (GR, GRf), **characterized in that** there is grafted, to the graphene, at least one functional group which can crosslink to a polymer matrix.

2. Reinforcer according to Claim 1, in the form of an individual thread, of an assembly of threads, of a tape or of a film.

3. Reinforcer according to claim 1 or 2, in which the surface metal is copper.

4. Reinforcer according to any one of Claims 1 to 2, in which the reinforcer is a reinforcer entirely of metal.

5. Reinforcer according to Claim 4, in which the metal at the core of the metal reinforcer is a steel, preferably a carbon steel.

6. Reinforcer according to Claim 5, in which the steel is coated, at least in part, with a metal referred to as "substrate metal" acting as substrate for the layer of the surface metal.

7. Reinforcer according to Claim 6, in which the substrate metal is selected from the group consisting of aluminium, cobalt, tin, manganese, molybdenum, zinc and the alloys comprising at least one of these elements.

8. Reinforcer according to Claim 7, in which the substrate metal is selected from the group consisting of cobalt, zinc and the alloys comprising at least one of these elements.

9. Reinforcer according to Claim 8, in which the substrate metal is brass.

10. Reinforcer according to any one of Claims 1 to 9, the thickness of the reinforcer, or its diameter when its cross section is circular in shape, being between 0.05 and 5 mm, preferably between 0.1 and 1 mm.

11. Reinforcer according to any one of Claims 1 to 10, in which the number of graphene layers varies from 1 to 5, preferably from 2 to 4.

12. Reinforcer according to any one of claims 1 to 11, in which the crosslinkable functional group comprises at least one function, denoted "GF", chosen from the - NH₂, - NHR (R a hydrocarbon radical), -OH, -COOH, -CHO, -SH, -Sₓ- (polysulphide, with "x" greater than 1), halogen, acrylate, methacrylate, epoxy, vinyl, vinyloxy or isocyanate functions.

13. Reinforcer according to Claim 12, in which the crosslinkable functional group corresponds to the formula: 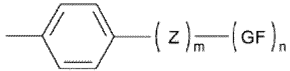 in which:
- "m" is equal to 0 or to 1;
- "n" is an integer from 1 to 5;
- Z is an optional, at least divalent, bonding group.

14. Reinforcer according to Claim 13, in which the crosslinkable functional group corresponds to the formula:
